# FASCICULE DE BREVET EUROPEEN

(11) **EP 0 895 091 B1**
(45) Date de publication et mention de la délivrance du brevet: **04.04.2007**
(21) Numéro de dépôt: 98109310.7
(22) Date de dépôt: 22.05.1998
(51) Int. Cl.: G01R 31/02, B60R 21/00

(54) **Méthode et circuit pour surveiller l'intégrité des conducteurs dans un arrangement d'éléments de circuit connectés en matrice**
Verfahren und Schaltkreis zur Integritätsüberwachung von Leitern in einer Anordnung von Schaltungselementen in einer Matrix
Method and circuit for monitoring the integrity of conductors in an arrangement of circuit elements connected in a matrix

(30) Priorité: 30.07.1997 LU 90116
(43) Date de publication de la demande: 03.02.1999
(73) Titulaire: IEE INTERNATIONAL ELECTRONICS & ENGINEERING S.A., 6468 Echternach (LU)
(72) Inventeur: Thinnes, Martin, 54311 Trierweiler (DE)
(74) Mandataire: Freylinger, Ernest T.

(56) Documents cités:
- WO-A-97/10115
- DE-C- 4 237 072
- PATENT ABSTRACTS OF JAPAN vol. 010, no. 389 (P-531), 26 décembre 1986 (1986-12-26) & JP 61 178674 A (TOSHIBA CORP), 11 août 1986 (1986-08-11)

## Description

La présente invention concerne une méthode et un circuit pour surveiller l'intégrité des conducteurs dans un arrangement d'éléments de circuit connectés en matrice.

Elle trouve son application p.ex. dans un détecteur d'occupation d'un siège automobile, qui comprend une pluralité de capteurs individuels répartis sur la surface du siège. Afin de réduire le nombre de connexions d'un tel ensemble de capteurs, il est avantageux de connecter les capteurs individuels en matrice n x m (n et m représentent des nombres entiers quelconques). Les capteurs sont connectés entre des conducteurs de ligne et des conducteurs de colonne aux points d'intersection des conducteurs et on relie les conducteurs de ligne et les conducteurs de colonne à une interface électronique d'évaluation.

On réalise de cette manière un circuit qui permet d'identifier individuellement les capteurs individuels à l'aide de n + m connecteurs.

Des réalisations de ce type et les interfaces électroniques adéquates sont connues depuis longtemps (par ex. TECHNOTES de INTERLINK ELECTRONICS EUROPE, Revision 4/90 ; Brevet US 5,505,072).

Dans des applications de sécurité, il est important de surveiller l'intégrité des conducteurs qui raccordent les capteurs afin d'être sûr qu'une non-détection n'est pas due à une interruption de conducteur ou à un mauvais contact. Une méthode classique consiste à retourner chaque conducteur, depuis son point le plus éloigné à l'interface électronique afin de vérifier son intégrité par un courant de test. Mais par cette méthode, le nombre des conducteurs augmente à (2 x n) + (2 x m). Un tel détecteur nécessite par conséquent un grand nombre de connexions avec l'extérieur.

L'objet de la présente invention est de proposer une méthode et un circuit pour surveiller l'intégrité des conducteurs dans un arrangement d'éléments de circuit connectés en matrice, qui permet de réduire le nombre de connexions avec l'extérieur.

Conformément à l'invention, cet objectif est atteint par une méthode pour surveiller l'intégrité d'un conducteur de ligne dans un arrangement d'éléments de circuit connectés en matrice n x m par n conducteurs de ligne et m conducteurs de colonne, chaque conducteur de ligne comprenant une extrémité libre et une extrémité de connexion, qui comprend les étapes de connecter un conducteur de colonne supplémentaire à l'extrémité libre de chacun des n conducteurs de ligne au moyen d'un élément de résistance, ledit conducteur de colonne supplémentaire comprenant une extrémité libre et une extrémité de connexion, et de mesurer la résistance entre l'extrémité de connexion dudit conducteur de colonne supplémentaire et l'extrémité de connexion dudit conducteur de ligne.

De manière analogue, une méthode pour surveiller l'intégrité d'un conducteur de colonne dans un arrangement d'éléments de circuit connectés en matrice n x m par n conducteurs de ligne et m conducteurs de colonne, chaque conducteur de colonne comprenant une extrémité libre et une extrémité de connexion, comprend les étapes de connecter un conducteur de ligne supplémentaire à l'extrémité libre de chacun des m conducteurs de colonne au moyen d'un élément de résistance, ledit conducteur de ligne supplémentaire ayant une extrémité libre et une extrémité de connexion, et de mesurer la résistance entre l'extrémité de connexion dudit conducteur de ligne supplémentaire et l'extrémités de connexion dudit conducteur de colonne.

En répétant l'étape de mesure de la résistance pour chaque conducteur de ligne et pour chaque conducteur de colonne, on peut donc aisément vérifier l'état de tous les conducteurs de la matrice.

Un circuit pour surveiller l'intégrité des conducteurs dans un arrangement d'éléments de circuit connectés en matrice n x m par n conducteurs de ligne et m conducteurs de colonne, chaque conducteur comprenant une extrémité libre et une extrémité de connexion, comprend par conséquent un conducteur de ligne supplémentaire, qui est connecté à l'extrémité libre de chacun des m conducteurs de colonne au moyen d'un élément de résistance fixe, et un conducteur de colonne supplémentaire, qui est connecté à l'extrémité libre de chacun des n conducteurs de ligne au moyen d'un élément de résistance fixe.

Il en suit qu'une matrice d'éléments de circuit équipé d'un tel circuit de surveillance nécessite seulement n+m+2 connexions avec l'extérieur, ce qui présente une réduction considérable par rapport à l'état de la technique décrit ci-dessus.

Dans une exécution avantageuse du circuit, le conducteur de ligne supplémentaire et le conducteur de colonne supplémentaire sont connectés à leur extrémité libre au moyen d'un élément de résistance. Ceci permet de contrôler en outre l'intégrité des deux connecteurs supplémentaires.

Les éléments de résistances fixes peuvent comprendre des diodes. Il est clair que les deux variantes peuvent également être combinées.

D'autres particularités et caractéristiques de l'invention ressortiront de la description détaillée de quelques modes de réalisation avantageux présentés ci-dessous, à titre d'illustration, en référence aux dessins annexés. Celles ci montrent:
- Fig.1:: un schéma de commutation en matrice d'un ensemble d'éléments de circuit, sans circuit de surveillance de l'intégrité;
- Fig.2:: le circuit de la figure 1, complété d'un premier mode de réalisation d'un circuit de surveillance de l'intégrité;
- Fig.3:: le circuit de la figure 1, complété d'un deuxième mode de réalisation d'un circuit de surveillance de l'intégrité.

L'exemple de réalisation se réfère à un détecteur de force à résolution latérale, qui peut être utilisé pour détecter l'occupation d'un siège d'un véhicule automobile. Le détecteur 2 comprend une pluralité de capteurs individuels 4 qui sont répartis sur la surface du siège et qui sont reliés à une interface électronique d'évaluation (non représentée).

Dans l'exécution avantageuse représentée sur les figures, le détecteur 2 à résolution latérale est réalisé à l'aide de capteurs de force dont la résistance électrique varie en fonction de la force appliquée. Ces capteurs de force sont connus sous le nom de FSR (force sensing resistor) et ils permettent de détecter directement la valeur de la force appliquée sur la surface active. Ces capteurs FSR sont représentés sur la figure par des résistances variables.

Un capteur FSR est décrit p.ex. dans le brevet US-A-4,489,302 et se compose de deux couches dont la première est formé d'un élément semi-conducteur et dont la deuxième présente deux peignes de conducteurs interdigités. A force nulle, les deux couches du capteur FSR sont distancées et la résistance entre les deux conducteurs est très élevée. Sous l'action d'une force, les deux conducteurs sont shuntés par la couche semi-conductrice et la résistance entre les deux conducteurs diminue en fonction de la force appliquée. Dans un autre type de capteurs FSR, deux conducteurs de forme quelconque sont séparés par une couche semi-conductrice intercalée. Sous l'action d'une force, les deux conducteurs et la couche semi-conductrice sont pressés ensemble et la résistance entre les deux conducteurs diminue en fonction de la force appliquée. Un tel capteur FSR est décrit p.ex. dans le brevet US-A-4,31 5,238.

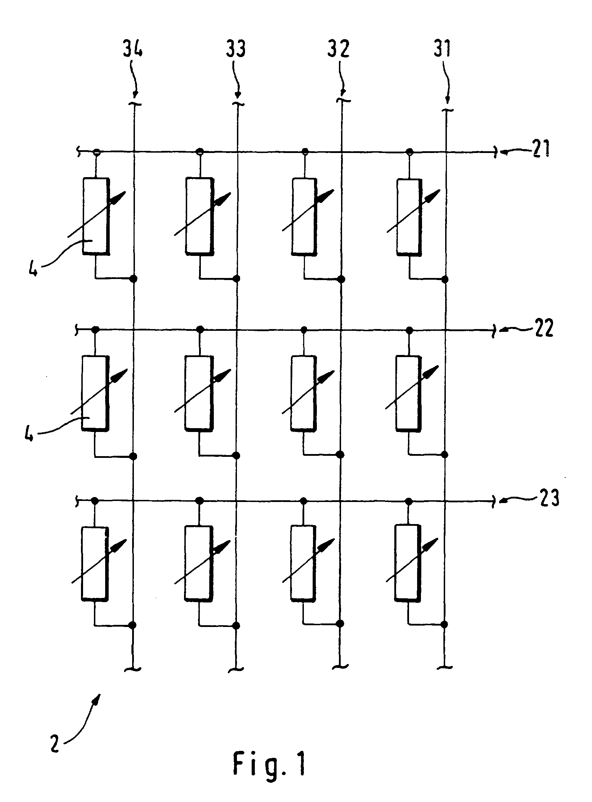

Pour réduire le nombre de connexions d'un ensemble de capteurs FSR, il est avantageux de connecter les capteurs FSR en matrice. La figure 1 montre une telle matrice qui est composée de n lignes 21, 22, ... et de m colonnes 31, 32, ... Les résistances variables qui constituent les capteurs FSR sont connectées entre les colonnes et les lignes aux points d'intersections. L'avantage de ce montage consiste donc à connecter m x n capteurs par seulement n + m conducteurs.

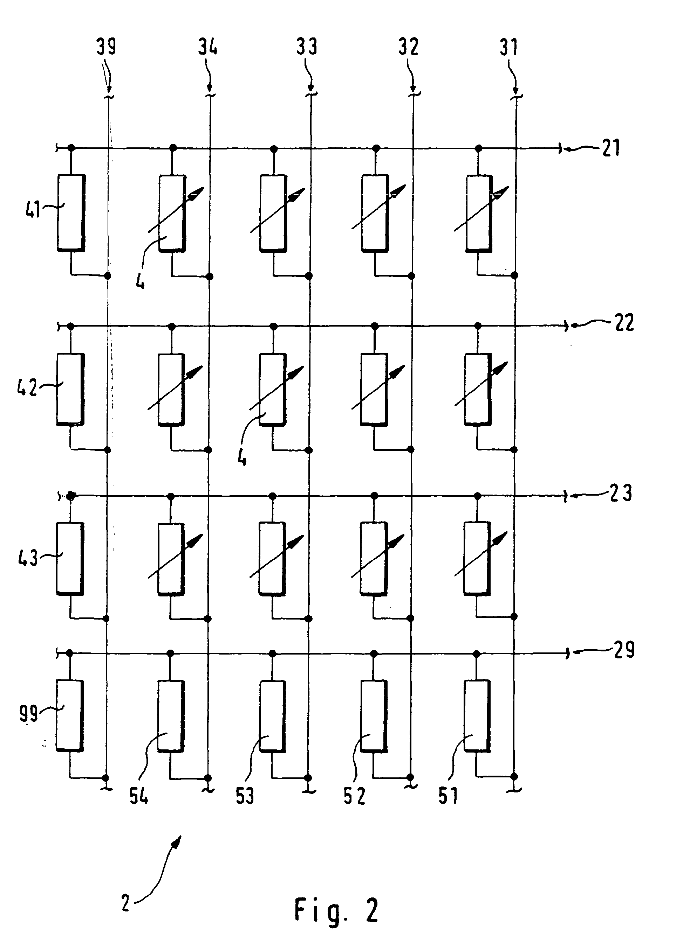

La figure 2 montre une première exécution d'un circuit de surveillance de l'intégrité des conducteurs. La méthode plus économique consiste à rajouter aux lignes 21, 22, ... une colonne 39 connectée aux extrémités des lignes par des résistances fixes 41, 42, ... et aux extrémités des colonnes 31, 32, ... une ligne 29 connectée aux colonnes par des résistances fixes 51, 52, ... . La résistance 99 est optionnelle mais ne nécessite aucune opération supplémentaire pour sa lecture par l'interface électronique. Elle facilite néanmoins la localisation d'une interruption dans un des conducteurs rajoutés pour la surveillance. Les résistances fixes sont mesurées de la même façon que les capteurs FSR mais conduisent le courant, sauf en cas de destruction, au contraire des capteurs FSR non activés par une force.

Lors du processus de fabrication des capteurs il est parfaitement possible de produire des résistances fixes sans frais supplémentaires et rajouter ainsi une surveillance de l'intégrité des conducteurs avec seulement deux conducteurs (contacts) supplémentaires.

Sans perdre la fonction de surveillance on peut doter les résistances 31, 32, ... et 41, 42, ... de fonctions de détection, à condition que la valeur maximale de la résistance électrique soit limitée et connue. Par exemple, la valeur de ces résistances peut être une fonction de la température. Ainsi il est possible soit d'obtenir des informations supplémentaires aux données fournies par les capteurs FSR, soit de compenser des erreurs des capteurs FSR en température ou en dérive dans le temps.

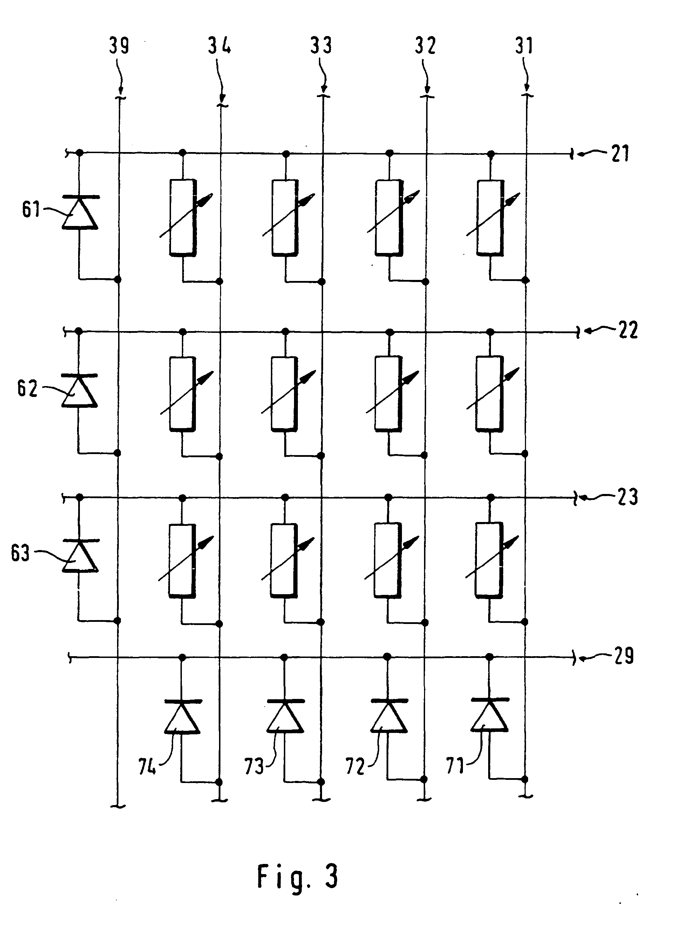

Une variante de la méthode de surveillance de l'intégrité des conducteurs est représentée dans la figure 3. Elle consiste à remplacer les résistances fixes 31, 32, ... et 41,42, ... par des diodes 61,62, ... et 71,72, ... . Cette variante plus coûteuse en production permet, par inversion de polarité, une mesure plus adéquate de la faible résistance des conducteurs. Bien sûr les deux variantes peuvent être combinées.

## Revendications

1. Méthode pour surveiller l'intégrité d'un conducteur de ligne dans un arrangement d'éléments de circuit (4) connectés en matrice n x m par n conducteurs de ligne (21, 22, 23) et m conducteurs de colonne (31, 32, 33, 34), chaque conducteur de ligne comprenant une extrémité libre et une extrémité de connexion, **caractérisé par** les étapes
a) de connecter un conducteur de colonne supplémentaire (39) à l'extrémité libre de chacun des n conducteurs de ligne (21, 22, 23) au moyen d'éléments de résistance (41, 42, 43), ledit conducteur de colonne supplémentaire (39) comprenant une extrémité libre et une extrémité de connexion, et
b) de mesurer la résistance entre l'extrémité de connexion dudit conducteur de colonne supplémentaire(39) et l'extrémité de connexion dudit conducteur de ligne à surveiller.

2. Méthode selon la revendication 1, **caractérisé en ce que** l'étape b) est répétée pour chacun des n conducteurs de ligne (21, 22, 23).

3. Méthode pour surveiller l'intégrité d'un conducteur de colonne dans un arrangement d'éléments de circuit (4) connectés en matrice n x m par n conducteurs de ligne (21, 22, 23) et m conducteurs de colonne (31, 32, 33, 34), chaque conducteur de colonne comprenant une extrémité libre et une extrémité de connexion, **caractérisé par** les étapes
a) de connecter un conducteur de ligne supplémentaire (29) à l'extrémité libre de chacun des m conducteurs de colonne (31, 32, 33, 34) au moyen d'éléments de résistance (51, 52, 53, 54), ledit conducteur de ligne supplémentaire (29) ayant une extrémité libre et une extrémité de connexion, et
b) de mesurer la résistance entre l'extrémité de connexion dudit conducteur de ligne supplémentaire (29) et l'extrémité de connexion dudit conducteur de colonne à surveiller.

4. Méthode selon la revendication 3, **caractérisé en ce que** l'étape b) est répétée pour chacun des m conducteurs de colonne (31, 32, 33, 34).

5. Méthode selon l'une des revendications 1 ou 2, **caractérisée par** les étapes
de connecter un conducteur de ligne supplémentaire (29) à l'extrémité libre de chacun des m conducteurs de colonne (31, 32, 33, 34) au moyen d'éléments de résistance (51, 52, 53, 54), ledit conducteur de ligne supplémentaire (29) ayant une extrémité libre et une extrémité de connexion,
de connecter le conducteur de ligne supplémentaire (29) et le conducteur de colonne supplémentaire (39) à leur extrémité libre au moyen d'un élément de résistance (99), et
de mesurer la résistance entre les extrémités libres respectives dudit conducteur de ligne supplémentaire (29) et dudit conducteur de colonne supplémentaire (39).

6. Méthode selon l'une des revendications 1 à 5, **caractérisé en ce que** les éléments de résistance (41, 42, 43, 51, 52, 53, 54) comprennent une résistance fixe.

7. Méthode selon l'une des revendications 1 à 5, **caractérisé en ce que** les éléments 5 de résistance comprennent une diode (61, 62, 63, 71, 72, 73, 74)..

8. Circuit pour surveiller l'intégrité des conducteurs dans un arrangement d'éléments de circuit connectés en matrice n x m par n conducteurs de ligne (21, 22, 23) et m conducteurs de colonne (31, 32, 33, 34), chaque conducteur comprenant une extrémité libre et une extrémité de connexion,
**caractérisé par**
un conducteur de ligne supplémentaire (29), qui est connecté à l'extrémité libre de chacun des m conducteurs de colonne (31, 32, 33, 34) au moyen d'éléments de résistance fixe (51, 52, 53, 54),
un conducteur de colonne supplémentaire (39), qui est connecté à l'extrémité libre de chacun des n conducteurs de ligne (21, 22, 23) au moyen d'éléments de résistance fixe (41, 42, 43), et
un moyen pour mesurer la résistance entre ledit conducteur de ligne supplémentaire (29) et un des conducteurs de colonne (31, 32, 33, 34) et la résistance entre ledit conducteur de colonne supplémentaire (39) et un des conducteurs de ligne (21, 22, 23).

9. Circuit selon la revendication 8, **caractérisé en ce que** le conducteur de ligne supplémentaire (29) et le conducteur de colonne supplémentaire (39) sont connectés à leur extrémité libre au moyen d'un élément de résistance fixe (99).

## Claims

1. Method for monitoring the integrity of a row conductor in an arrangement of circuit elements (4) connected in an n x m matrix by n row conductors (21, 22, 23) and m column conductors (31, 32, 33, 34), each row conductor comprising one free end and one connection end, **characterized by** the steps.
a) connecting an additional column conductor (39) to the free end of each of the n row conductors (21, 22, 23) by means of resistance elements (41, 42, 43), the additional column conductor (39) comprising one free end and one connection end, and
b) measuring the resistance between the connection end of the additional column conductor (39) and the connection end of the row conductor to be monitored.

2. Method according to Claim 1, **characterized in that** step b) is repeated for each one of the n row conductors (21, 22, 23)

3. Method for monitoring the integrity of a column conductor in an arrangement of circuit elements (4) connected in an n x m matrix by n row conductors (21, 22, 23) and m column conductors (31, 32, 33, 34), each column conductor comprising one free end and one connection end, **characterized by** the steps:
a) connecting an additional row conductor (29) to the free end of each of the n column conductors (31, 32, 33, 34) by means of resistance elements (51, 52, 53, 54), the additional row conductor (29) comprising one free end and one connection end, and
b) measuring the resistance between the connection end of the additional row conductor (29) and the connection end of the column conductor to be monitored.

4. Method according to Claim 3, **characterized in that** step b) is repeated for each one of the m column conductors (31, 32, 33, 34)

5. Method according to Claim 1 or 2, **characterized by** the steps of
connecting an additional row conductor (29) to the free end of each of the m column conductors (31, 32, 33, 34) by means of resistance elements (51, 52, 53, 54), the additional row conductor (29) comprising one free end and one connection end,
connecting the additional row conductor (29) and the additional column conductor (39) to their free ends by means of a resistance element (99), and
measuring the resistance between the respective free ends of the additional row conductor (29) and the additional column conductor (39)

6. Method according to any one of Claims 1 to 5, **characterized in that** the resistance elements (41, 42, 43, 51, 52, 53, 54) comprise a fixed resistance

7. Method according to any one of Claims 1 to 5, **characterized in that** the resistance elements comprise a diode (61, 62, 63, 71, 72, 73, 74)

8. Circuit for monitoring the integrity of the conductors in an arrangement of circuit elements connected in an n x m matrix by n row conductors (21, 22, 23) and m column conductors (31, 32, 33, 34), each conductor comprising one free end and one connection end, **characterized by**
an additional row conductor (29) which is connected to the free end of each of the m column conductors (31, 32, 33, 34) by means of fixed resistance elements (51, 52, 53, 54),
an additional column conductor (39) which is connected to the free end of each of the n row conductors (21, 22, 23) by means of fixed resistance elements (41, 42, 43), and
a means for measuring the resistance between the additional row conductor (29) and one of the column conductors (31, 32, 33, 34) and the resistance between the additional column conductor (39) and one of the row conductors (21, 22, 23).

9. Circuit according to Claim 8, **characterized in that** the additional row conductor (29) and the additional column conductor (39) are connected at their free ends by means of a fixed resistance element (99)

## Patentansprüche

1. Verfahren zur Unversehrtheitsüberwachung eines Zeilenleiters in einer Anordnung von Schaltungselementen (4), die in einer n x m-Matrix durch n Zeilenleiter (21, 22, 23) und m Spaltenleiter (31, 32, 33, 34) miteinander verschaltet sind, wobei jeder Zeilenleiter ein freies Ende und ein Anschlussende umfasst, **gekennzeichnet durch** die Schritte
a) des Anschließens eines zusätzlichen Spaltenleiters (39) an das freie Ende eines jeden der n Zeilenleiter (21, 22, 23) mittels Widerstandselementen (41, 42, 43), wobei der zusätzliche Spaltenleiter (39) ein freies Ende und ein Anschlussende umfasst, und
b) des Messens des Widerstandes zwischen dem Anschlussende des zusätzlichen Spaltenleiters (39) und dem Anschlussende des zu überwachenden Zeilenleiters.

2. Verfahren nach Anspruch 1, **dadurch gekennzeichnet, dass** der Schritt b) für jeden der n Zeilenleiter (21, 22, 23) wiederholt wird

3. Verfahren zur Unversehrtheitsüberwachung eines Spaltenleiters in einer Anordnung von Schaltungselementen (4), die in einer n x m-Matrix durch n Zeilenleiter (21, 22, 23) und m Spaltenleiter (31, 32, 33, 34) miteinander verschaltet sind, wobei jeder Spaltenleiter ein freies Ende und ein Anschlussende umfasst, **gekennzeichnet durch** die Schritte
a) des Anschließens eines zusätzlichen Zeilenleiters (29) an das freie Ende eines jeden der m Spaltenleiter (31, 32, 33, 34) mittels Widerstandselementen (51, 52, 53, 54), wobei der zusätzliche Zeilenleiter (29) ein freies Ende und ein Anschlussende aufweist, und
b) des Messens des Widerstandes zwischen dem Anschlussende des zusätzlichen Zeilenleiters (29) und dem Anschlussende des zu überwachenden Spaltenleiters

4. Verfahren nach Anspruch 3, **dadurch gekennzeichnet, dass** der Schritt b) für jeden der m Spaltenleiter (31, 32, 33, 34) wiederholt wird

5. Verfahren nach einem der Ansprüche 1 oder 2, **gekennzeichnet durch** die Schritte
des Anschließens eines zusätzlichen Zeilenleiters (29) an das freie Ende eines jeden der m Spaltenleiter (31, 32, 33, 34) mittels Widerstandselementen (51, 52, 53, 54), wobei der zusätzliche Zeilenleiter (29) ein freies Ende und ein Anschlussende aufweist,
des Anschließens des zusätzlichen Zeilenleiters (29) und des zusätzlichen Spaltenleiters (39) an ihrem freien Ende mittels eines Widerstandselementes (99), und
des Messens des Widerstandes zwischen den jeweiligen freien Enden des zusätzlichen Zeilenleiters (29) und des zusätzlichen Spaltenleiters (39)

6. Verfahren nach einem der Ansprüche 1 bis 5, **dadurch gekennzeichnet, dass** die Widerstandselemente (41, 42, 43, 51, 52, 53, 54) einen Festwiderstand umfassen

7. Verfahren nach einem der Ansprüche 1 bis 5, **dadurch gekennzeichnet, dass** die Widerstandselemente eine Diode (61, 62, 63, 71, 72, 73, 74) umfassen

8. Schaltkreis zur Unversehrtheitsüberwachung von Leitern in einer Anordnung von Schaltungselementen, die in einer n x m-Matrix durch n Zeilenleiter (21, 22, 23) und m Spaltenleiter (31, 32, 33, 34) miteinander verschaltet sind, wobei jeder Leiter ein freies Ende und ein Anschlussende umfasst, **gekennzeichnet durch**
einen zusätzlichen Zeilenleiter (29), der mit dem freien Ende eines jeden der m Spaltenleiter (31, 32, 33, 34) mittels Festwiderstandselementen (51, 52, 53, 54) verbunden ist,
einen zusätzlichen Spaltenleiter (39), der mit dem freien Ende eines jeden der n Zeilenleiter (21, 22, 23) mittels Festwiderstandselementen (41, 42, 43) verbunden ist, und
ein Mittel zum Messen des Widerstandes zwischen dem zusätzlichen Zeilenleiter (29) und einem der Spaltenleiter (31, 32, 33, 34) und des Widerstandes zwischen dem zusätzlichen Spaltenleiter (39) und einem der Zeilenleiter (21, 22, 23)

9. Schaltkreis nach Anspruch 8, **dadurch gekennzeichnet, dass** der zusätzliche Zeilenleiter (29) und der zusätzliche Spaltenleiter (39) an ihrem freien Ende mittels eines Festwiderstandselementes (99) verbunden sind.
